# DEMANDE DE BREVET EUROPEEN

(11) **EP 4 166 379 A1**
(43) Date de publication de la demande: **19.04.2023**
(21) Numéro de dépôt: 22196435.6
(22) Date de dépôt: 19.09.2022
(51) Int. Cl.: B60L 53/53, B60L 55/00, B60L 53/63, H02J 3/32, H02M 5/12, H02M 7/68

(54) **DISPOSITIF DE RECHARGE RAPIDE D'UN VEHICULE AUTOMOBILE**

(30) Priorité: 15.10.2021 FR 2110953
(71) Demandeur: NW Joules, 75007 Paris (FR)
(72) Inventeur: KERDELHUÉ, Jean-Christophe, 75007 PARIS (FR)
(74) Mandataire: Cabinet Laurent & Charras

(57) **Abrégé**

L'invention concerne un équipement d'équilibrage (10a) d'un réseau comportant :
une entrée de réseau (11);
un transformateur (21c) comportant un premier enroulement connecté en sortie de ladite entrée de réseau ;
un premier onduleur (15c) connecté sur ledit transformateur (14) ;
un ensemble de batteries (17) connectées sur ledit premier onduleur ;
un organe de supervision (22) configuré pour activer ledit premier onduleur et assurer la charge ou la décharge desdites batteries lorsqu'un déséquilibre est détecté ; et
un second onduleur (23c) connecté en entrée sur ledit second enroulement dudit transformateur et en sortie sur au moins une prise de recharge (24) d'un véhicule électrique ou hybride; ledit organe de supervision étant configuré pour activer ledit second onduleur lorsqu'un besoin de charge est détecté sur ladite prise de recharge et que les besoins d'injection sur le réseau sont inférieurs à une valeur seuil.

## Description

### Domaine technique

L'invention concerne le domaine des dispositifs de recharge de véhicules automobiles, tels qu'une voiture ou un bus électrique ou hybride. Ces dispositifs de recharge sont également appelés « bornes de recharge » et peuvent être implantés dans divers endroits, tels que les parkings privés, les parkings publics de magasins ou de restaurants par exemple.

L'invention vise plus particulièrement une borne de recharge dite « rapide ».

### Art antérieur

Le développement des véhicules électriques ou hybrides s'accompagne naturellement d'un développement des solutions de recharge de ces véhicules. Un des points bloquant le développement de l'usage des véhicules uniquement électriques est le temps de recharge de ces véhicules. En effet, ce temps de recharge est bien supérieur à celui nécessaire pour faire le plein de carburant d'un véhicule thermique. Ainsi, pour parcourir des longues distances, un conducteur utilise plus facilement un véhicule thermique ou hybride qu'un véhicule uniquement électrique.

La recharge d'un véhicule électrique (ou hybride) est réalisée en rechargeant une ou plusieurs batteries connectées sur le réseau électrique du véhicule. Pour ce faire, l'énergie électrique est classiquement consommée sur un réseau électrique présentant une tension alternative. La borne de recharge a pour fonction de transformer la tension alternative du réseau à un niveau de tension adapté à la batterie et de transformer la tension alternative en une tension continue.

Une borne de recharge classique est connectée à un réseau électrique fonctionnant en 220V alternatif et elle comporte une entrée de réseau connectée à un transformateur abaissant la tension alternative à un niveau de l'ordre de 50V relié à un convertisseur alternatif/continu connecté à une prise de charge du véhicule électrique.

Avec ce type de bornes de recharge largement démocratisées, une recharge complète d'un véhicule électrique prend typiquement 8 à 12 heures.

Cependant, le soutirage réalisé par plusieurs bornes de recharge sur un réseau peut entrainer des dégradations au niveau des performances du réseau. En effet, dans un réseau électrique, la consommation doit toujours être équilibrée avec la production au risque de faire varier les caractéristiques du réseau, notamment sa fréquence. Pour ce faire, le gestionnaire du réseau peut utiliser des réserves primaires, secondaires et tertiaires, qui interviennent à des échelles de temps et de puissance différentes. Par exemple, la réserve primaire présente un délai d'action inférieur à 30 secondes, la réserve secondaire présente un délai d'action inférieur à 15 min et la réserve tertiaire présente un délai d'action de 30 min.

Ainsi, lorsqu'un déséquilibre est constaté, les réserves primaires s'activent automatiquement en fonction des écarts de fréquence mesurés entre le réseau et un signal de référence élaboré par le gestionnaire de réseau de transport. En effet, lorsqu'un déséquilibre se produit entre la production et la consommation, la fréquence du réseau s'écarte du niveau requis de 50 Hz et cet écart active la réserve primaire des entités participant à cette réserve primaire. Chacune de ces entités doit augmenter sa puissance d'injection si la fréquence est inférieure à 50 Hz ou diminuer sa puissance d'injection voire soutirer du courant, si la fréquence est supérieure à 50 Hz. Un nouveau point d'équilibre entre la production et la consommation est ainsi obtenu sur le réseau.

Pour obtenir la réactivité nécessaire, la réserve primaire comporte des entités de réserve connectées sur le réseau haute tension ou le réseau moyenne tension. En effet, un réseau de transport d'énergie électrique est classiquement structuré avec plusieurs niveaux de tension, par exemple des lignes haute-tension transportent le courant avec une tension entre 50kV et 400kV, des lignes moyenne-tension avec une tension entre 1kV et 50kV et des lignes basse-tension avec une tension de 220V. Ces lignes sont interconnectées avec des postes de transformation disposés entre les différents types de lignes.

Un équipement utilisant des batteries pour participer en tant qu'entité de réserve à la réserve primaire comporte classiquement un ensemble de batteries de très forte capacité chargées à moitié de leur capacité pour pourvoir, le cas échéant, injecter ou soutirer de la puissance sur le réseau. De même, cet équipement participe au réglage de tension suivant le cahier des charges du gestionnaire de réseau, en injectant ou soutirant de la puissance réactive.

La réserve primaire doit être dimensionnée pour injecter ou restituer une part non négligeable de la production et de la consommation du réseau. En Europe, l'ensemble des entités de réserve formant la réserve primaire représentent une capacité de 3000MW, soit la puissance de production des deux plus gros réacteurs nucléaires en service. Pour obtenir cette puissance totale, chaque entité de réserve doit être dimensionnée pour présenter une capacité d'au moins 1 MW.

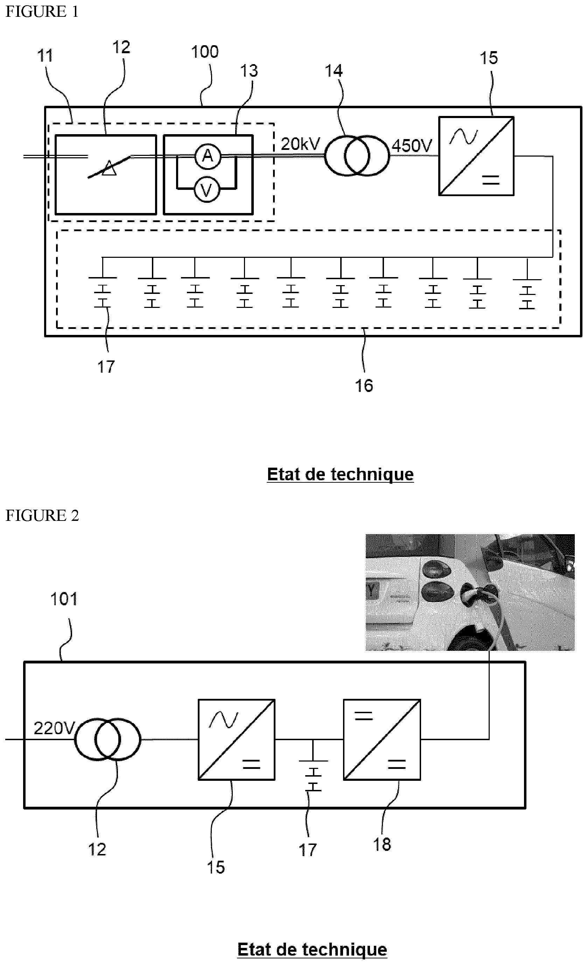

Plus précisément, tel qu'illustré sur la figure 1, un équipement d'équilibrage **100** à batteries **17** comporte une entrée de réseau **11** intégrant des organes de protection **12** du réseau haute-tension ou moyenne-tension et des organes de mesure **13** des performances du réseau pour détecter les besoins d'équilibrage en puissance et en tension. Cette entrée de réseau est connectée à un transformateur **14** abaissant la tension. Par exemple, lorsque l'équipement d'équilibrage est connecté sur le réseau moyenne-tension, le transformateur peut être configuré pour transformer une tension alternative de 20kV en une tension alternative de 450V. La sortie du transformateur **14** est connectée à un onduleur **15** configuré pour convertir la tension alternative en une tension continue alimentant un ensemble **16** de batteries **17.** Un organe de supervision, non représenté, mesure les puissances active et réactive du réseau au cours du temps et commande la charge ou la décharge des batteries **17** pour compenser les déséquilibres du réseau.

Pour limiter la puissance souscrite de raccordement de l'équipement au réseau, il est également connu des bornes de recharges **101** pour véhicules électriques intégrant une ou plusieurs batteries, tel qu'illustré sur la figure 2. Ce type de borne de recharge **101** intègre un transformateur **12** abaissant la tension alternative du réseau basse-tension suivi d'un onduleur **15** connecté à une batterie **17** et configuré pour adapter le niveau de tension à la batterie **17.**

La sortie de l'onduleur **15** est également connectée à un convertisseur continu/continu **18** connecté à une prise de charge du véhicule électrique et configuré pour adapter le niveau de tension au véhicule électrique. Lorsque la demande de puissance dépasse une valeur seuil, la batterie **17** est utilisée de sorte à limiter les contraintes qui seraient imposées au réseau.

En outre, la batterie **17** peut être rechargée après la phase de charge d'un véhicule électrique. Bien que ce mode de réalisation limite la puissance instantanée soutirée sur le réseau, le temps de recharge n'est pas amélioré par rapport à une borne de recharge classique.

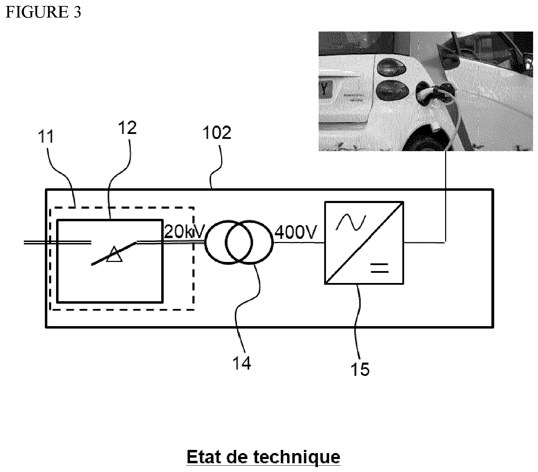

Pour améliorer la vitesse de recharge, il est possible d'utiliser une borne de recharge directement connectée sur le réseau haute-tension ou sur le réseau moyenne-tension de sorte à pouvoir fournir une puissance maximale au véhicule électrique. Tel qu'illustré sur la figure 3, ce type de borne de recharge **102** intègre une entrée de réseau **11** intégrant des organes de protection **12** du réseau haute-tension ou moyenne-tension et un transformateur **14** abaissant la tension.

La sortie du transformateur **14** est connectée à un onduleur **15** configuré pour convertir la tension alternative en une tension continue alimentant la prise de recharge du véhicule électrique. Avec ce type de borne de recharge, la recharge d'un véhicule électrique peut être réalisée en 20 min.

Bien que cette solution soit efficace pour améliorer la vitesse de recharge d'un véhicule électrique, l'encombrement et le coût des organes de protection **12** nécessaires pour être autorisé à se raccorder sur le réseau haute-tension ou moyenne-tension sont prohibitifs pour le déploiement de ce type de bornes de recharge.

Pour résoudre ces problèmes, le Demandeur a mis en place une solution décrite dans le document WO2021/069188 et permettant de raccorder directement un dispositif de recharge rapide d'un véhicule électrique sur un équipement de réserve primaire utilisant des batteries.

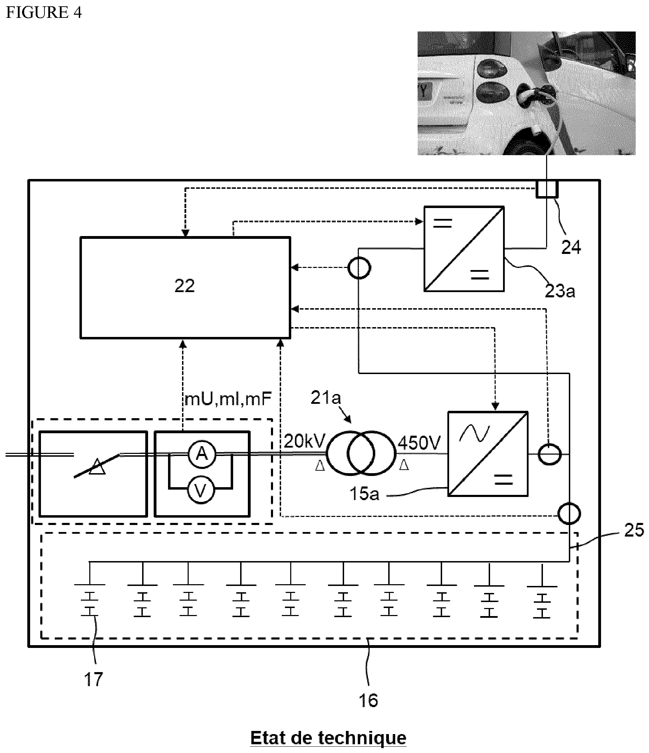

Pour ce faire, tel qu'illustré sur la figure 4, un organe de supervision **22** commande un onduleur **15a** et un convertisseur continu/continu **23a.** L'onduleur **15a** est disposé entre le transformateur **21a** et les batteries de stockage **17** de sorte à former un équipement de réserve primaire, tel que décrit en référence à la figure 1. En outre, le convertisseur **23a** est relié à la borne de recharge rapide **24.** En fonction de l'état du réseau, l'organe de supervision **22** assure à la fois la charge ou la décharge des batteries **17** lorsqu'un équilibrage est nécessaire sur le réseau et l'activation de la borne de recharge rapide **24,** lorsqu'un besoin de charge est détecté et que les besoins d'injection sur le réseau sont inférieurs à une valeur seuil.

Le document WO 2021/069188 concerne en particulier le raccordement de la borne de recharge rapide **24** sur un bus **25** qui alimente les batteries de stockage **17.** Pour ce faire, le convertisseur **23a** est relié entre la borne de recharge rapide **24** et le bus **25.**

Afin de mesurer la puissance consommée pour alimenter la borne de recharge, et notamment facturer le coût de la recharge utilisée, celle-ci doit être munie d'un compteur d'énergie. Pour la solution décrite en référence à la figure 4, l'énergie utilisée pour alimenter la borne de recharge rapide **24** provient, soit de l'onduleur **15a** transformant un courant alternatif en un courant continu, soit des batteries de stockage **17,** également connectées sur le bus **25** en courant continu. Ainsi, il est nécessaire de mesurer la puissance consommée par la borne de recharge rapide **24** en utilisant une mesure de courant continu. Cependant, les organes de mesure de courant continu sont plus rares et plus complexes à mettre en œuvre que ceux permettant la mesure de courant alternatif. En outre, certains pays, tels que la France, ne reconnaissent pas encore la précision des organes de mesure de courant continu.

Une solution alternative, décrite dans le document WO 2021/069189 et illustrée sur la figure 5, consiste à connecter la borne de recharge rapide **24** sur un enroulement supplémentaire d'un transformateur **21b** comportant au moins trois enroulements. Un onduleur **23b** est ainsi positionné entre l'enroulement supplémentaire du transformateur **21b** et la borne de recharge rapide **24** de sorte à transformer un courant alternatif, prélevé au niveau du transformateur **21b,** en un courant continu permettant d'alimenter la borne de recharge rapide **24.**

Cette solution permet de prélever un courant alternatif pour alimenter la borne de recharge rapide **24,** soit provenant directement du réseau et passant par le transformateur **21b,** soit provenant des batteries de stockage **17,** en passant par l'onduleur **15b** et le transformateur **21b.** Il est ainsi possible d'utiliser un organe de mesure de courant alternatif pour mesurer la puissance consommée pour alimenter la borne de recharge rapide **24.**

Cependant, cette solution nécessite d'utiliser un transformateur présentant un enroulement supplémentaire. Il s'ensuit que cette solution est plus complexe et couteuse à mettre en œuvre.

Le problème technique que se propose de résoudre l'invention consiste donc à obtenir un équipement d'équilibrage, intégrant une borne de recharge rapide, plus économique et plus simple à mettre en œuvre que les dispositifs existants et permettant d'utiliser des organes de mesure de l'énergie certifiés.

### Exposé de l'invention

Pour répondre à ce problème technique, l'invention propose d'utiliser un second onduleur dont l'entrée est connectée entre le transformateur et un premier onduleur alimentant les batteries de stockage et dont la sortie est connectée à la borne de recharge.

En effet, l'homme du métier des équipements d'équilibrage sait qu'il est particulièrement important de limiter les harmoniques transmises sur le réseau et traversant un transformateur connecté à un réseau moyenne tension ou haute tension. Ces harmoniques peuvent notamment causer des échauffements anormaux des dispositifs électriques connectés sur le réseau voire des dégradations de ces dispositifs.

En outre, il est également connu de l'homme du métier des équipements d'équilibrage que pour limiter la génération d'harmoniques, il convient de limiter la charge sur chaque enroulement du transformateur.

Ainsi, pour connecter une borne de recharge d'un véhicule électrique, l'homme du métier utiliserait soit la solution décrite dans le document WO 2021/069188, dans laquelle un seul enroulement du transformateur est connecté avec un seul onduleur, soit la solution décrite dans le document WO 2021/069189, dans laquelle deux enroulements distincts du transformateur sont connectés à deux onduleurs distincts. Il s'ensuit qu'il ne chercherait pas à branche deux onduleurs sur un même enroulement d'un transformateur.

L'invention est issue d'une observation selon laquelle la connexion de deux onduleurs sur un même enroulement de sortie d'un transformateur connecté au réseau moyenne tension ou haute tension génère des harmoniques limités qui permettent tout de même d'obtenir les résultats escomptés.

Ainsi, l'utilisation d'un second onduleur, connecté entre le transformateur et un premier onduleur, permet de simplifier le système, car il n'est pas nécessaire d'utiliser un transformateur spécifique ou un organe de mesure spécifique. En effet, le second onduleur étant connecté sur un courant alternatif, la consommation de la borne de recharge peut simplement être mesurée sur le courant alternatif consommé par le second onduleur, sans qu'il ne soit nécessaire d'utiliser un organe de mesure de courant continu, plus rare et plus complexe à mettre en œuvre. En outre, un transformateur classique peut être utilisé.

De même, la configuration de l'invention permet de ne faire transiter l'énergie provenant des batteries de stockage, que par deux onduleurs, en évitant ainsi le transformateur. Le rendement énergétique entre l'énergie prélevée sur les batteries et l'énergie effectivement fournie à la borne de recharge est ainsi amélioré par rapport aux solutions utilisant un transformateur à trois enroulements.

A cet effet, selon un premier aspect, l'invention concerne un équipement d'équilibrage d'un réseau haute-tension ou moyenne-tension comportant :
- une entrée de réseau intégrant des organes de protection dudit réseau et des organes de mesure des performances dudit réseau pour détecter les besoins d'équilibrage ;
- un transformateur comportant un premier enroulement connecté en sortie de ladite entrée de réseau et configuré pour abaisser la tension dudit réseau ;
- un premier onduleur connecté sur un second enroulement dudit transformateur et configuré pour transformer une tension alternative en une tension continue ;
- un ensemble de batteries connectées sur ladite tension continue ; et
- un organe de supervision configuré pour activer ledit premier onduleur et assurer la charge ou la décharge desdites batteries lorsqu'un déséquilibre est mesuré sur ledit réseau par lesdits organes de mesure.

L'invention se caractérise en ce que ledit équipement d'équilibrage comporte également un second onduleur connecté en entrée sur ledit second enroulement dudit transformateur et en sortie sur au moins une prise de recharge d'un véhicule électrique ou hybride ; et des moyens de détection d'un besoin de charge de ladite prise de recharge ; ledit organe de supervision étant configuré pour activer ledit second onduleur lorsqu'un besoin de charge est détecté sur ladite prise de recharge et que les besoins d'injection sur le réseau sont inférieurs à une valeur seuil.

Ainsi, l'invention permet d'utiliser un équipement d'équilibrage pour recharger un véhicule électrique ou hybride sauf dans les phases pour lesquelles une grande quantité de puissance doit être injectée sur le réseau. En effet, dans un équipement d'équilibrage, les phases d'injection et de soutirage sont normalement relativement courtes, souvent quelques dizaines de secondes. Comparativement au temps de recharge d'un véhicule électrique ou hybride, ces instants de soutirage ou d'injection sont très faibles.

Comparativement à une borne de recharge classique, la borne de recharge réalisée par l'invention est beaucoup plus rapide, puisqu'elle est connectée sur le réseau haute-tension ou moyenne-tension. Ainsi, bien qu'elle ne soit pas disponible tout le temps, car la borne de recharge réalisée par l'invention n'est pas utilisable lorsque l'équipement d'équilibrage doit injecter une grande quantité de puissance sur le réseau, l'amélioration de la vitesse de recharge au cours des autres phases compense largement les instants dans lesquels la borne de recharge ne peut pas être utilisée pour charger un véhicule électrique ou hybride.

En outre, comparée aux bornes de recharge rapide de l'état de la technique, le coût d'installation de la borne de recharge de l'invention est moindre puisque les organes de protection nécessaires pour être autorisé à se raccorder sur le réseau haute-tension ou moyenne-tension sont communs pour l'équipement d'équilibrage et la borne de recharge ce qui limite le nombre de composants nécessaires à l'installation de la borne de recharge.

L'invention est donc issue d'une découverte selon laquelle l'indisponibilité de la borne de recharge dans les instants de forte injection d'un équipement d'équilibrage est compensée par le gain en vitesse de recharge et ne dégrade pas de manière notable la durée de vie des batteries intégrées dans les véhicules électriques ou hybrides.

En effet, il est connu que les coupures dans les phases de charge dégradent la durée de vie des batteries intégrées dans les véhicules électriques ou hybrides. Or, il a été mesuré une durée de vie sensiblement constante pour des batteries Lithium-ion intégrées dans les véhicules électriques ou hybrides même en utilisant une borne de recharge conforme à l'invention, c'est-à-dire avec des instants d'indisponibilité pouvant intervenir dans les phases de charge.

Selon un mode de réalisation, lesdits organes de mesure des performances dudit réseau pour détecter les besoins d'équilibrage comportent un compteur d'énergie dédié au gestionnaire dudit réseau et un compteur d'énergie indépendant, ledit compteur d'énergie indépendant étant configuré pour mesurer la consommation en courant alternatif captée en entrée dudit second onduleur. Le compteur dédié au gestionnaire de réseau permet classiquement, dans un équipement d'équilibrage, de permettre au gestionnaire de réseau de vérifier que l'équipement d'équilibrage est actif selon le contrat imposé par le gestionnaire de réseau. Par exemple, le gestionnaire de réseau peut avoir imposé comme contrainte que l'équipement d'équilibrage effectue un soutirage de 10% de puissance active lorsque la fréquence dépasse une valeur seuil ou tout autre mode de prévention du réseau et, de même, un soutirage de 10% de puissance réactive lorsque la tension dépasse une valeur seuil ou tout autre mode de prévention du réseau. Le compteur indépendant permet de vérifier la réalisation du contrat par le prestataire. En outre, dans le cadre de l'invention, le compteur indépendant peut être utilisé pour mesurer la puissance soutirée sur le réseau pour alimenter la borne de recharge et non pour équilibrer le réseau.

Pour mettre en œuvre l'invention, il est nécessaire de configurer l'organe de supervision pour permettre l'injection et le soutirage sur le réseau tout en utilisant le même réseau pour alimenter le second onduleur dans les phases pour lesquelles l'injection maximum n'est pas nécessaire. Pour ce faire, la méthode la plus simple est d'autoriser le fonctionnement du second onduleur lorsque la prise de recharge est utilisée et que l'injection maximum sur le réseau n'est pas requise. Dans ce mode de réalisation, lesdits moyens de détection d'un besoin de charge de ladite prise de recharge correspondent à un capteur configuré pour détecter une consommation sur ladite prise de recharge.

De préférence, la commande du premier onduleur et du second onduleur peut dépendre à la fois des besoins d'équilibrage du réseau et des besoins de soutirage de la borne de recharge. Ainsi, un compromis peut être recherché entre ces deux besoins lorsque les besoins d'injection sur le réseau ne sont pas maximaux.

Dans ce mode de réalisation, lesdits moyens de détection d'un besoin de charge de ladite prise de recharge correspondent à une sonde de mesure de la puissance de recharge demandée sur ladite prise de recharge.

En outre, dans ce mode de réalisation, ledit équipement d'équilibrage comporte préférentiellement une sonde disposée en entrée dudit premier onduleur de sorte à mesurer une puissance instantanée en énergie alternative consommée par ledit ensemble de batteries, une sonde disposée sur ladite tension continue dudit ensemble de batteries de sorte à mesurer une puissance instantanée en énergie continue consommée par ledit ensemble de batteries, et sonde disposée en entrée dudit second onduleur de sorte à mesurer une puissance instantanée en énergie alternative consommée par ladite prise de recharge.

Avec ces trois sondes, l'organe de supervision est capable de détecter la puissance utilisée sur le premier onduleur et le second onduleur pour équilibrer le soutirage réalisé sur le réseau en fonction des besoins de soutirage pour alimenter la prise de recharge et pour maintenir l'ensemble des batteries au point d'équilibre correspondant sensiblement à la moitié de la capacité totale de chacune des batteries.

Pour ce faire, selon un second aspect, l'invention concerne un procédé de gestion d'un équipement d'équilibrage selon le premier aspect de l'invention, ledit procédé comportant les étapes suivantes :
mesure de la différence entre une mesure de tension, une mesure de fréquence et une mesure de courant du réseau et des valeurs nominales pour déterminer les besoins d'injection et/ou de soutirage de puissance active et/ou réactive ;
détermination d'une puissance de commande du premier onduleur connecté à l'ensemble des batteries en fonction des besoins d'injection et/ou de soutirage ;
si les besoins d'injection sont supérieurs à une puissance maximum d'injection, désactivation du second onduleur et activation du premier onduleur connecté à l'ensemble de batteries pour injecter ladite puissance maximum d'injection,
si les besoins d'injection sont inférieurs à une puissance maximum d'injection, désactivation du second onduleur et activation du premier onduleur connecté à l'ensemble de batteries pour injecter ladite puissance de commande,
si les besoins de soutirage sont inférieurs à une puissance de recharge demandée sur ladite prise de recharge et que le niveau de charge de l'ensemble des batteries est supérieur à une valeur seuil, désactivation du premier onduleur connecté à l'ensemble de batteries et activation du second onduleur pour soutirer ladite puissance de commande, et
si les besoins de soutirage sont supérieurs à une puissance de recharge demandée sur ladite prise de recharge et que le niveau de charge de l'ensemble des batteries est inférieur à une valeur seuil, activation du premier onduleur et du second onduleur jusqu'à ce que le niveau de charge de l'ensemble des batteries soit supérieur à ladite valeur seuil.

De préférence, ladite puissance de commande est déterminée en fonction de pertes de charge estimées à partir de mesures issues de trois sondes respectivement disposées en sortie dudit premier onduleur, entre ledit second onduleur et ladite tension continue et sur ladite tension continue dudit ensemble de batteries.

### Description sommaire des figures

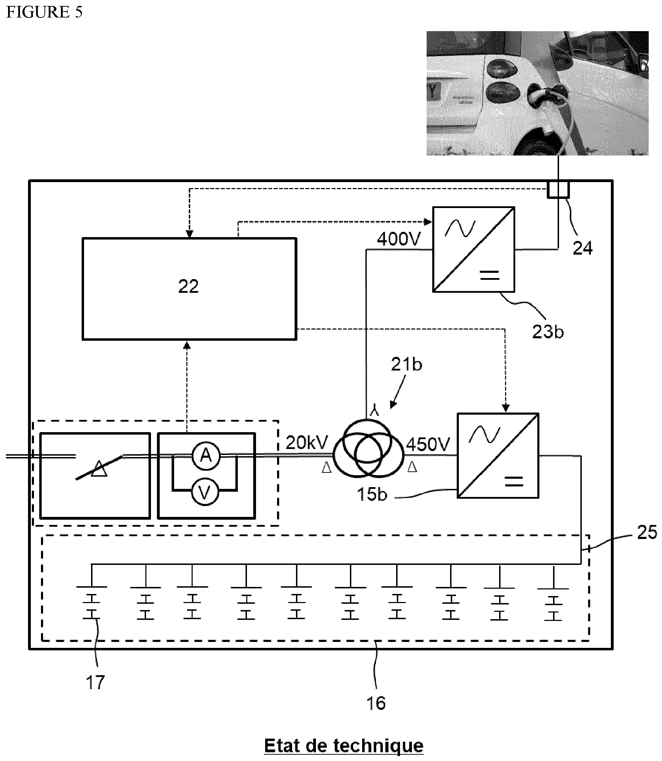

La manière de réaliser l'invention ainsi que les avantages qui en découlent, ressortiront bien des modes de réalisation qui suivent, donnés à titre indicatif mais non limitatif, à l'appui des figures 1 à 6 qui constituent :
La figure 1 est une représentation schématique d'un équipement d'équilibrage à batteries de l'état de la technique ;
La figure 2 est une représentation schématique d'une borne de recharge à batterie de l'état de la technique ;
La figure 3 est une représentation schématique d'une borne de recharge « rapide » de l'état de la technique ;
La figure 4 est une représentation schématique d'un équipement d'équilibrage de l'état de la technique selon un premier mode de réalisation ;
La figure 5 est une représentation schématique d'un équipement d'équilibrage de l'état de la technique selon un deuxième mode de réalisation ;
La figure 6 est une représentation schématique d'un équipement d'équilibrage selon un mode de réalisation de l'invention, et
La figure 7 est un ordinogramme des étapes de gestion d'un organe de supervision de l'équipement d'équilibrage de la figure 6.

### Description détaillée de l'invention

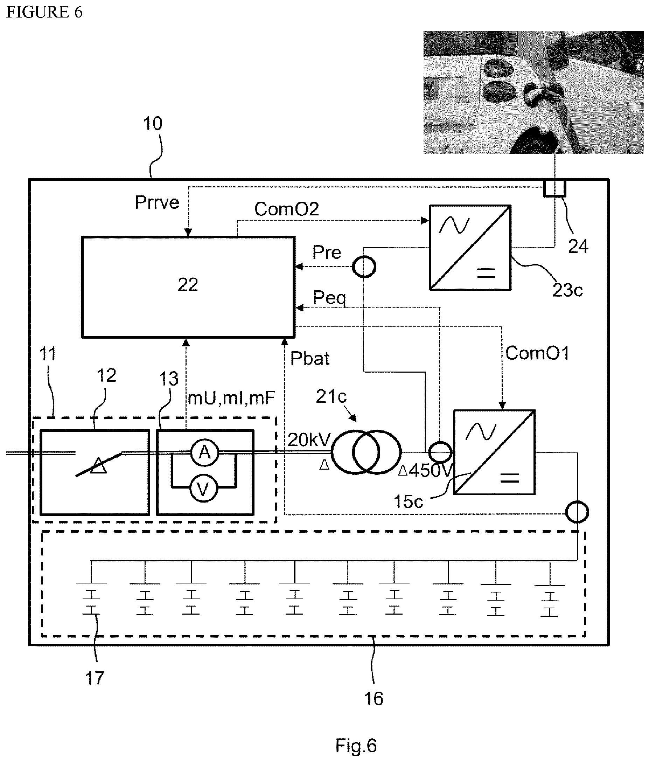

La figure 6 illustre un équipement d'équilibrage **10** formant également une borne de recharge pour un véhicule électrique ou hybride. Cet équipement d'équilibrage **10** comporte classiquement une entrée de réseau **11** intégrant des organes de protection **12** et des organes de mesure **13.** L'entrée de réseau **11** peut être connectée au réseau haute-tension ou moyenne-tension. Par exemple, l'entrée de réseau **11** peut être connectée à deux câbles électriques distincts transportant chacun une tension de 20 kV. En outre, l'entrée de réseau **11** peut également comprendre une sortie de réseau permettant à un des deux câbles de traverser l'entrée de réseau **11** de sorte à former un équipement d'équilibrage traversé par le réseau.

Les organes de protection **12** correspondent typiquement à des disjoncteurs haute-tension ou moyenne-tension, par exemple des disjoncteurs commandés pouvant sectionner un courant de 400 A afin de protéger l'équipement d'équilibrage **10.** De préférence, les câbles réseaux entrent dans l'entrée de réseaux **11** sur des disjoncteurs manuels permettant de réaliser des opérations de maintenance dans l'équipement d'équilibrage **10.** Un disjoncteur automatique est préférentiellement monté à la sortie de ces disjoncteurs manuels de sorte à sectionner le courant traversant l'entrée de réseaux **11** lorsque les appels de courant à l'intérieur de l'équipement d'équilibrage **10** sont supérieurs à une valeur seuil. Ainsi, ces organes de protection **12** sont préférentiellement couplés avec des organes de mesure **13** de sorte à détecter les instants pour lesquels il convient de sectionner le courant traversant l'entrée de réseaux **11.**

Ces organes de mesure **13** ont également pour fonction de mesurer la fréquence, la tension ainsi que le déphasage entre l'intensité et cette tension, le tout afin de de détecter les besoins d'équilibrage du réseau en puissance active et réactive. De préférence, ces organes de mesure **13** intègrent plusieurs compteurs d'énergie : un compteur d'énergie associé au gestionnaire de réseau et un compteur d'énergie indépendant associé à l'exploitant de l'équipement d'équilibrage **10.** Ces compteurs d'énergie sont préférentiellement connectés à un réseau de communication filaire ou sans fil.

Ainsi, le gestionnaire du réseau peut obtenir des informations concernant les besoins d'équilibrage en temps réel en utilisant les mesures réalisées par les organes de mesure **13** de l'équipement d'équilibrage **10.** De même, les mesures réalisées par le compteur d'énergie indépendant peuvent être transmises à l'exploitant de l'équipement d'équilibrage **10** pour contrôler la quantité d'énergie injectée ou soutirée sur le réseau.

Les organes de mesure **13** transmettent au moins trois informations à un organe de supervision **22** : une mesure de tension **mU,** une mesure de fréquence **mF** et une mesure de courant **mI,** l'organe de supervision **22** étant configuré pour calculer le déphasage entre le courant et la tension. En variante, les organes de mesure **13** peuvent comporter des moyens de détection automatique du déphasage entre la tension et le courant et ce déphasage peut être transmis à l'organe de supervision **22.**

L'organe de supervision **22** a pour fonction première d'identifier les besoins d'équilibrage du réseau et de combler ces besoins en fonction de l'état de charge des batteries **17** intégrées dans l'équipement d'équilibrage **10.** Cet organe de supervision **22** peut se présenter sous la forme d'un microcontrôleur ou d'un microprocesseur associé à une suite d'instructions. De plus, cet organe de supervision **22** peut être contrôlé à distance, par exemple par l'exploitant de l'équipement d'équilibrage **10** afin de mettre à jour les stratégies d'équilibrage ou les autorisations de recharge des véhicules électriques ou hybrides.

Pour réaliser l'équilibrage ou la recharge d'un véhicule électrique ou hybride, la sortie de l'entrée de réseau **11** est connectée sur un transformateur **21c** comportant au moins deux enroulements. Le premier enroulement et préférentiellement câblé en triangle et reçoit la tension de 20 kV du réseau. Ce premier enroulement est couplé à un second enroulement préférentiellement également câblé en triangle avec une tension abaissée à 450 V. Le transformateur **21c** peut également présenter un troisième enroulement permettant par exemple de brancher des instruments de mesure.

La tension alternative abaissée à 450 V est connectée à un premier onduleur **15c** permettant de transformer la tension alternative en une tension continue alimentant l'ensemble **16** des batteries **17.** De préférence, la sortie du premier onduleur **15c** présente un niveau de tension continu compris entre 700 et 1000 V. Le premier onduleur **15c** transforme également la tension continue de l'ensemble **16** des batteries **17** en tension alternative, fonctionnant ainsi comme un onduleur bidirectionnel.

En outre, La tension alternative abaissée à 450 V est également connectée à un second onduleur **23c,** lui-même connecté à une prise de recharge d'un véhicule électrique ou hybride **24.** Le second onduleur **23c** permet de transformer la tension alternative abaissée à 450 V en une tension continue alimentant la prise de recharge **24.** De préférence, la sortie du second onduleur **23c** présente un niveau de tension continu de 50 V. Le second onduleur **23c** peut également transformer la tension continue en tension alternative, par exemple pour utiliser ponctuellement la charge des batteries pour alimenter le réseau, fonctionnant comme un onduleur bidirectionnel.

Outre ces éléments essentiels à la réalisation de l'invention, d'autres éléments peuvent être mis en œuvre pour améliorer la sécurité ou les stratégies de commande de l'équipement d'équilibrage **10.** Par exemple, la figure 6 illustre des sondes disposées après le transformateur **21c** pour mesurer la puissance en différents points de l'équipement d'équilibrage **10.** Plus précisément, une première sonde est disposée en entrée du premier onduleur **15c** pour mesurer la puissance **Peq** en énergie alternative consommée par l'ensemble des batteries **17.** Une seconde sonde est disposée en entrée du second onduleur **23c** pour mesurer la puissance consommée **Pre** en énergie alternative par la prise de recharge **24.** Ces deux sondes permettent, avec l'organes de mesure **13,** d'estimer les pertes liées au transformateur **21c** et de mesurer l'énergie réactive, c'est-à-dire le déphasage, appliqué par le premier et le second onduleur **15c, 23c.** Cette seconde sonde peut également transmettre à un compteur d'énergie des informations concernant la quantité de courant alternatif consommée par les prises de recharge **24.**

Une sonde disposée sur la tension continue de l'ensemble **16** des batteries **17** permet de mesurer une puissance instantanée **Pbat** en énergie continue consommée par l'ensemble **16** des batteries **17.**

Avec la première sonde disposée en entrée du premier onduleur **15c** pour mesurer la puissance **Peq,** la sonde disposée sur la tension continue de l'ensemble **16** des batteries **17** permet d'estimer les pertes liées au premier onduleur **15c.**

Pour adapter la stratégie d'équilibrage des deux onduleurs **15c** et **23c,** il suffit de détecter une consommation ou, à tout le moins, une présence sur la prise de recharge **24** au moyen d'un signal Ep, tel qu'illustré sur la figure 6. De préférence, la puissance de recharge demandée **Prrve** par la prise de recharge **24** est mesurée par une sonde disposée au niveau de la prise de recharge **24** afin de fournir une information à l'organe de supervision **22.**

À partir de ces différentes informations transmises à l'organe de supervision **22,** l'organe de supervision **22** peut déterminer la stratégie à opérer par les onduleurs **15c** et **23c.**

Outre ces éléments structurels permettant de recharger un véhicule électrique ou hybride et d'effectuer l'équilibrage du réseau, les équipements d'équilibrage **10** peuvent intégrer des éléments classiques d'un équipement d'équilibrage, tels qu'un groupe froid permettant le refroidissement du transformateur **21c** ou de l'ensemble des batteries **17,** une alarme, une centrale de protection contre les incendies...

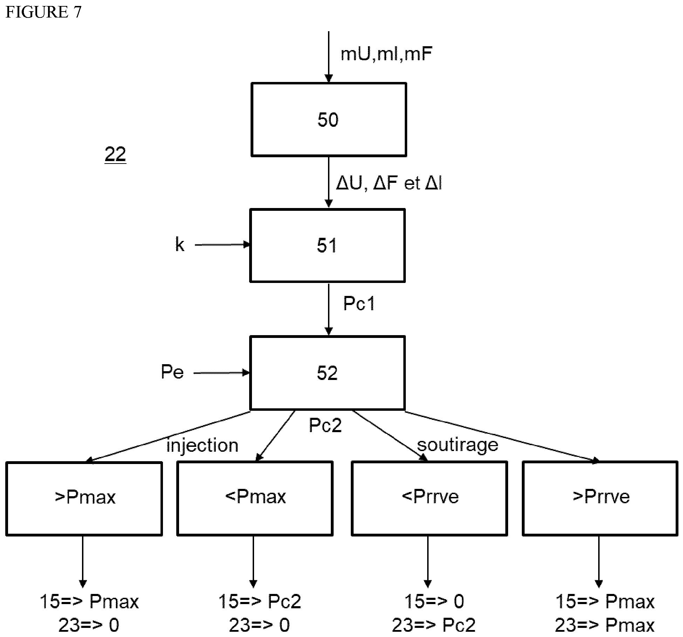

La figure 7 illustre un exemple de procédé de gestion des deux onduleurs **15c** et **23c** mis en œuvre par l'organe de supervision **22.** Dans une première étape **50,** ce procédé mesure la différence entre la tension **mU,** la fréquence **mF** et le courant **ml** et des valeurs nominales pour détecter les besoins **ΔU, ΔI, ΔF** d'injection ou de soutirage sur le réseau de puissance réactive et/ou active. Ainsi, lorsque la différence entre une grandeur nominale et grandeur mesurée **mU, mF, mI** dépasse une valeur seuil, un besoin d'injection ou de soutirage est déterminé en fonction de cette différence. La seconde étape **51** vise à déterminer la puissance à appliquer au premier onduleur **15c** en fonction des besoins **Pc1** d'injection ou de soutirage et d'un coefficient **k.** Ces besoins **Pc1** sont ensuite précisés dans une seconde étape **52** de détermination en prenant en compte les pertes réelles au niveau du transformateur **21c.** Ces pertes réelles peuvent être estimées par les différentes sondes en fonction de l'état des onduleurs **15c** et **23c.**

Les besoins **Pc2** obtenus à l'issue de l'étape **52** peuvent être appliqués en fonction de plusieurs scénarii prédéfinis, par exemple :
- si les besoins d'injection **ΔU, ΔF, ΔI** sont supérieurs à une puissance maximum d'injection **Pmax,** désactivation du second onduleur **23c** et activation du premier onduleur **15c** connecté à l'ensemble de batteries **17** pour injecter la puissance maximum d'injection **Pmax,**
- si les besoins d'injection **ΔU, ΔF, ΔI** sont inférieurs à une puissance maximum d'injection **Pmax,** désactivation du second onduleur **23c** et activation du premier onduleur **15c** connecté à l'ensemble de batteries **17** pour injecter la puissance de commande **Pc1** ou **Pc2,**
- si les besoins de soutirage **ΔU, ΔF, ΔI** sont inférieurs à une puissance de recharge demandée **Prrve** sur la prise de recharge **24** et que le niveau de charge de l'ensemble des batteries **17** est supérieur à une valeur seuil, désactivation du premier onduleur **15c** connecté à l'ensemble de batteries **17** et activation du second onduleur **23c** pour soutirer la puissance de commande **Pc1** ou **Pc2,** et
- si les besoins de soutirage **ΔU, ΔF, ΔI** sont supérieurs à une puissance de recharge demandée **Prrve** sur la prise de recharge **24** et que le niveau de charge de l'ensemble des batteries **17** est inférieur à une valeur seuil, activation des deux onduleurs **15c, 23c** jusqu'à ce que le niveau de charge de l'ensemble des batteries **17** soit supérieur à la valeur seuil.

L'invention permet ainsi d'obtenir un équipement d'équilibrage **10** permettant, outre l'équilibrage du réseau, de recharger un véhicule électrique ou hybride de manière très rapide puisque l'équipement d'équilibrage est directement connecté sur le réseau haute-tension ou moyenne tension. L'invention permet donc d'obtenir une borne de recharge « rapide » à moindre coût car elle réutilise les composants existants dans l'équipement d'équilibrage **10,** notamment au niveau de l'entrée de réseau **11.** En outre, l'invention permet également d'utiliser un transformateur **21c** et un compteur de courant alternatif consommé par la prise de recharge simples à mettre en œuvre.

## Revendications

1. Equipement d'équilibrage (10) d'un réseau haute-tension ou moyenne-tension comportant :
- une entrée de réseau (11) intégrant des organes de protection (12) dudit réseau et des organes de mesure (13) des performances dudit réseau pour détecter les besoins d'équilibrage ;
- un transformateur (21c) comportant un premier enroulement connecté en sortie de ladite entrée de réseau (11) et configuré pour abaisser la tension dudit réseau ;
- un premier onduleur (15c) connecté sur un second enroulement dudit transformateur (21c) et configuré pour transformer une tension alternative en une tension continue ;
- un ensemble de batteries (17) connectées sur ladite tension continue ; et
- un organe de supervision (22) configuré pour activer ledit premier onduleur (15c) et assurer la charge ou la décharge desdites batteries (17) lorsqu'un déséquilibre est mesuré sur ledit réseau par lesdits organes de mesure (13) ;
***caractérisé en ce que*** ledit équipement d'équilibrage (10) comporte également un second onduleur (23c) connecté en entrée sur ledit second enroulement dudit transformateur (21c) et en sortie sur au moins une prise de recharge (24) d'un véhicule électrique ou hybride ; et des moyens de détection d'un besoin de charge de ladite prise de recharge (24) ; ledit organe de supervision (22) étant configuré pour activer ledit second onduleur (23c) lorsqu'un besoin de charge est détecté sur ladite prise de recharge (24) et que les besoins d'injection sur le réseau sont inférieurs à une valeur seuil.

2. Equipement d'équilibrage selon la revendication 1, ***dans lequel*** lesdits organes de mesure (13) des performances dudit réseau pour détecter les besoins d'équilibrage comportent un compteur d'énergie dédié au gestionnaire dudit réseau et un compteur d'énergie indépendant, ledit compteur d'énergie indépendant étant configuré pour mesurer la consommation en courant alternatif captée en entrée dudit second onduleur (23c)

3. Equipement d'équilibrage selon la revendication 1 ou 2, ***dans lequel*** lesdits moyens de détection d'un besoin de charge de ladite prise de recharge (24) correspondent à une sonde de mesure de la puissance de recharge demandée (Prrve) sur ladite prise de recharge (24).

4. Equipement d'équilibrage selon l'une des revendications 1 à 3, ***dans lequel*** ledit équipement d'équilibrage (10) comporte une sonde disposée en entrée dudit premier onduleur (15c) de sorte à mesurer une puissance instantanée (Peq) en énergie alternative consommée par ledit ensemble de batteries (17).

5. Equipement d'équilibrage selon l'une des revendications 1 à 4, ***dans lequel*** ledit équipement d'équilibrage (10) comporte une sonde disposée sur ladite tension continue dudit ensemble de batteries (17) de sorte à mesurer une puissance instantanée (Pbat) en énergie continue consommée par ledit ensemble de batteries (17).

6. Equipement d'équilibrage selon l'une des revendications 1 à 5, ***dans lequel*** ledit équipement d'équilibrage (10) comporte une sonde disposée en entrée dudit second onduleur (23c) de sorte à mesurer une puissance instantanée (Pre) en énergie alternative consommée par ladite prise de recharge (24).

7. Procédé de gestion d'un équipement d'équilibrage selon l'une des revendications 1 à 6, ledit procédé comportant les étapes suivantes :
mesure (50) de la différence entre une mesure de tension (mU), une mesure de fréquence (mF) et une mesure de courant (mI) du réseau et des valeurs nominales pour déterminer les besoins d'injection et/ou de soutirage (ΔU, ΔF, ΔI);
détermination (51, 52) d'une puissance de commande (Pcl, Pc2) du second onduleur (15) connecté à l'ensemble des batteries (17) en fonction des besoins d'injection et/ou de soutirage (ΔT, ΔF, ΔC) de puissance active et/ou réactive ;
si les besoins d'injection (ΔT, ΔF, ΔC) sont supérieurs à une puissance maximum d'injection (Pmax), désactivation du second onduleur (23c) et activation du premier onduleur (15c) connecté à l'ensemble de batteries (17) pour injecter ladite puissance maximum d'injection (Pmax),
si les besoins d'injection (ΔT, ΔF, ΔC) sont inférieurs à une puissance maximum d'injection (Pmax), désactivation du second onduleur (23c) et activation du premier onduleur (15c) connecté à l'ensemble de batteries (17) pour injecter ladite puissance de commande (Pcl, Pc2),
si les besoins de soutirage (ΔT, ΔF, ΔC) sont inférieurs à une puissance de recharge demandée (Prrve) sur ladite prise de recharge (24) et que le niveau de charge de l'ensemble des batteries (17) est supérieur à une valeur seuil, désactivation du premier onduleur (15c) connecté à l'ensemble de batteries (17) et activation du second onduleur (23c) pour soutirer ladite puissance de commande (Pcl, Pc2), et
si les besoins de soutirage (ΔT, ΔF, ΔC) sont supérieurs à une puissance de recharge demandée (Prrve) sur ladite prise de recharge (24) et que le niveau de charge de l'ensemble des batteries (17) est inférieur à une valeur seuil, activation du premier onduleur (15c) et du second onduleur (23c) jusqu'à ce que le niveau de charge de l'ensemble des batteries (17) soit supérieur à ladite valeur seuil.

8. Procédé de gestion selon la revendication 7, ***dans lequel*** ladite puissance de commande (Pcl, Pc2) est déterminée (52) en fonction de pertes de charge (Pe) estimées à partir de mesures (Peq, Pre, Pbat) issues de trois sondes respectivement disposées en entrée dudit premier onduleur (15c), en entrée dudit second onduleur (23c) et sur ladite tension continue dudit ensemble de batteries (17).
